(19) **Europäisches Patentamt / European Patent Office / Office européen des brevets**

(11) **EP 4 585 930 A1**

(12) # EUROPEAN PATENT APPLICATION

(43) Date of publication:
**16.07.2025 Bulletin 2025/29**

(21) Application number: **24151174.0**

(22) Date of filing: **10.01.2024**

(51) International Patent Classification (IPC):
**G01R 15/06** (2006.01)    **G01R 15/14** (2006.01)
**G01R 15/16** (2006.01)    **H01R 24/64** (2011.01)
**H04Q 1/02** (2006.01)

(52) Cooperative Patent Classification (CPC):
**G01R 15/16; G01R 15/06; G01R 15/144; H01R 24/64**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **3M Innovative Properties Company**
**Saint Paul, MN 55133-3427 (US)**

(72) Inventors:
- **Gravermann, Mark**
  **41812 Erkelenz (DE)**
- **Gunjaca, Mirco**
  **48301 Nottuln (DE)**

(74) Representative: **Müller, Bruno**
**3M Deutschland GmbH**
**Carl-Schurz-Straße 1**
**41453 Neuss (DE)**

(54) **SIGNAL CABLE AND SENSING SYSTEM**

(57) A signal cable (210) for conducting a sensor signal received from a voltage sensor (300) of a sensored insulation plug (1) for being inserted into a rear cavity (70) of a medium-voltage or high-voltage separable connector (10) in a power distribution network of a national grid, and operable to insulate a connection element (80) of the separable connector (10) on an elevated voltage and to sense the elevated voltage. The signal cable (210) includes a connector (211). The connector (211) is adapted to be mechanically and electrically connected to the voltage sensor (300) of the sensored insulation plug (1). The signal cable (210) further includes a compensating assembly (310) including one or more discrete compensating capacitors (311) and the connector (211) is adapted to electrically connect the compensating assembly (310) to the voltage sensor (300) of the sensored insulation plug (1).

FIG. 6

**Description**

The invention relates to a signal cable conducting a sensor signal received from a voltage sensor of a sensored insulation plug. The invention further relates to a sensing system for sensing an elevated voltage of a medium-voltage or high-voltage separable connector including the signal cable.

Power networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensing devices in electrical installations at key locations of their network, such as in switchgears or transformers to collect information about the current state of their power network.

In a medium-voltage or high-voltage power distribution network, a power cable is typically connected to network apparatus, such as switchgears or transformers, by a separable connector, also often referred to as a removable power connector or a T-body connector, mounted at the end of the power cable. Such separable connectors have a front cavity to receive a protruding portion of a bushing of the network apparatus, and a connection element on high or medium voltage. The connection element is in electrical contact with a cable conductor and can be mechanically and electrically connected to the bushing, e.g., via a threaded stud accessible through an opposed rear cavity of the separable connector. After installation, the rear cavity is filled by inserting a so-called insulation plug, which insulates the connection element.

Elements of a voltage sensor for measuring the voltage of the connection element of a separable connector - and thereby the voltage of the power cable - can be integrated into the insulation plug, making it a "sensored insulation plug". A voltage sensor of that type is described, for example, in the U.S. patent US 6,031,368 and in the European patent application published as EP 3 070 481 A1. Often, such voltage sensors use voltage dividers to sense the voltage. For the high voltages involved, capacitive voltage dividers are generally considered advantageous as they do not require a conductive connection with components on the high voltage and are thereby inherently safer.

A frequency response of the sensored insulation plug must be compensated to achieve customer requirements. The customer requirements may be typically of $\pm 1$ % ratio change up to 3 kilohertz (kHz). Without the frequency response compensation, a circuit of the voltage sensor may have a very distinct low pass character. Further, an amplitude may be reduced significantly and there may also be a large phase displacement between an input high voltage and a sensor output voltage. This may be due to a positive temperature coefficient (PTC) resistor, mounted for example on a printed circuit board (PCB), of the sensored insulation plug. The PTC resistor may be needed for temperature compensation purposes.

The frequency response of the sensored insulation plug with the PTC resistor at its output generally depends on a capacitor value of a compensating capacitor connected in parallel to the PTC resistor. This compensating capacitor is used for the frequency response compensation. The compensating capacitor is typically mounted directly onto the PCB of the sensored insulation plug.

A signal cable is used to connect the sensored insulation plug with a processing device for processing the sensor signal. A capacitance of the signal cable may change with a change in a length of the signal cable. Therefore, the frequency response also depends on the length of the signal cable. Since different customers may need signal cables having different lengths in their substations as per their desired applications, the capacitance also changes. The capacitance of the signal cable may have a large effect on the frequency response of the sensored insulation plug. Thus, the capacitor value of the compensating capacitor must be changed for the signal cables having the different lengths.

However, as the compensating capacitor is mounted directly onto the PCB of the sensored insulation plug, a different PCB may be needed for each signal cable of a different length.

Therefore, it may be desirable to eliminate a need to change the compensating capacitor of the PTC resistor mounted on the PCB and/or the PCB of the sensored insulation plug for the signal cables having the different lengths.

In an attempt to address this need, in a first aspect, the present disclosure provides a signal cable for conducting a sensor signal received from a voltage sensor of a sensored insulation plug for being inserted into a rear cavity of a medium-voltage or high-voltage separable connector in a power distribution network of a national grid, and operable to insulate a connection element of the separable connector on an elevated voltage and to sense the elevated voltage. The signal cable includes a connector disposed at an end of the signal cable. The connector is adapted to be mechanically and electrically connected to the voltage sensor of the sensored insulation plug. The signal cable further includes a compensating assembly including one or more discrete compensating capacitors and the connector is adapted to electrically connect the compensating assembly to the voltage sensor of the sensored insulation plug upon mechanical and electrical connection of the connector with the voltage sensor of the sensored insulation plug.

Therefore, the signal cable of the present disclosure includes the compensating assembly including the one or more discrete compensating capacitors for frequency response compensation. The compensating assembly may be operable to be electrically connected in parallel to a PTC resistor of the sensored insulation plug upon mechanical and electrical connection of the connector with the voltage sensor of the sensored insulation plug.

The term "discrete capacitor" or "discrete compensating capacitor", as used herein, refers to an individual capacitor having an individual nominal capacitance that exists independently from the structure of the connector, of the compensating assembly, or of the signal cable. A surface-mount capacitor is an example of a discrete capacitor. In contrast to a discrete capacitor, an integrated capacitor is formed by structural elements of the connector, of the compensating assembly or of the signal cable rather than by a separate, discrete electrical device. For example, an integrated capacitor can be formed by two conductive patches on opposed sides of a circuit board, with the material of the circuit board forming the dielectric of the integrated capacitor. A further example of an integrated capacitor is a capacitor formed by a metal block (first electrode) and a tubular conductive metal sheet (second electrode) enveloping the metal block at a distance, both the block and the sheet embedded in a body of insulating material, where the insulating material between the block and the sheet forms the dielectric of the integrated capacitor.

The present disclosure relates to sensored insulation plugs for use in medium-voltage or high-voltage power distribution networks in which electrical power is distributed over large geographic areas via HV/MV power cables, transformers, switchgears, substations etc. with currents of tens or hundreds of amperes and voltages of tens of kilovolts. The term "medium voltage" or "MV" as used herein refers to AC voltages in the range of 1 kilovolt (kV) to 72 kV rms, whereas the term "high voltage" or "HV" refers to AC voltages of more than 72 kV rms. Medium voltage and high voltage are collectively referred to herein as "elevated voltage".

Since the signal cable includes the compensating assembly for the frequency response compensation, a nominal capacitance of the compensating assembly may be selected based on a capacitance of the signal cable. For example, the nominal capacitance of the compensating assembly may be selected based on a capacitance of the signal cable due to its length. Since there may be no need to mount a compensating capacitor directly onto a PCB of the sensored insulation plug, there may be no need to change the compensating capacitor on the PCB and/or a PCB including the compensating capacitor for signal cables having different lengths for use with the sensored insulation plug. A signal cable of a certain length can thus have a compensating capacitor or a compensating assembly of appropriate capacitance built into the cable. Specifically, no compensating capacitor needs to be part of a sensored insulation plug. Adequate frequency compensation can thus be achieved for any cable length without having to adapt the sensored insulation plug. This may allow identical sensored insulation plugs to be manufactured in larger quantities and hence more cost-effective, while maintaining good frequency compensation.

In some embodiments, the compensating assembly is electrically isolated from other electrical components when the connector is mechanically and electrically disconnected from the voltage sensor of the sensored insulation plug.

The compensating assembly may therefore provide a frequency response compensation and may not interfere with the other electrical components of the connector when the connector is mechanically and electrically disconnected from the voltage sensor of the sensored insulation plug.

In some embodiments, the compensating assembly includes two terminals, and the connector further includes two electric contacts electrically connected to the two terminals and operable to electrically connect the compensating assembly to the voltage sensor of the sensored insulation plug.

The two electric contacts of the connector electrically connected to the two terminals of the compensating assembly may therefore electrically connect the compensating assembly to the voltage sensor of the sensored insulation plug when the connector is mechanically and electrically connected to the voltage sensor of the sensored insulation plug.

In some embodiments, the signal cable further includes one or more signal lines electrically connected to two respective signal contacts of the connector and operable to conduct the sensor signal from the voltage sensor of the sensored insulation plug upon mechanical and electrical connection of the connector with the voltage sensor of the sensored insulation plug, and the two electric contacts are electrically isolated from the one or more signals lines when the connector is mechanically and electrically disconnected from the voltage sensor of the sensored insulation plug.

The two electric contacts of the connector electrically connected to the two terminals of the compensating assembly are therefore isolated from the one or more signal lines when the connector is mechanically and electrically disconnected from the voltage sensor of the sensored insulation plug.

In some embodiments, the compensating assembly is operable to be electrically connected in parallel to a resistor of the sensored insulation plug upon mechanical and electrical connection of the connector with the voltage sensor of the sensored insulation plug.

The compensating assembly electrically connected in parallel to the resistor may provide better frequency response compensation due to the resistor.

In some embodiments, the connector is a RJ45-type connector. The RJ45 type connector may be a commonly used connector and may provide a standardised, reliable, and cost-effective interface.

In some embodiments, a nominal capacitance of the compensating assembly is selected based on a capacitance of the signal cable without the compensating assembly.

The nominal capacitance of the compensating assembly may be selected based on the capacitance of the signal cable due to a length of the signal cable. For example, the capacitance of the signal cable without the compensating assembly may be greater for longer signal cables. Therefore, a greater value of the nominal capacitance of the compensating assembly may be selected for the longer signal cables. In other words, when the capacitance of the signal cable is higher (e.g., due to a greater length), a higher nominal capacitance of the compensating assembly may be selected.

In some embodiments, the nominal capacitance of the compensating assembly is between 1 nanofarad (nF) and 500 nF.

The nominal capacitance of between 1 nF and 500 nF may be suitable for the signal cables of common or desirable lengths. For example, the nominal capacitance of between 1 nF and 500 nF may be suitable for the signal cables of 1 meter to about 20 meters in length.

In some embodiments, the signal cable further includes a distal connector disposed at an opposing end of the signal cable. The distal connector is operable to connect the signal cable with a processing device for processing the sensor signal. The distal connector is operable to connect the signal cable with a processing device for processing the sensor signal directly, i.e., without intermediate elements, or indirectly, via intermediate elements. The processing device may be operable to process the sensor signal to determine and/or output the sensor signal and/or one or more signal parameters based on the sensor signal. The processing device may be operable to derive the elevated voltage from the sensor signal.

In some embodiments, the compensating assembly is disposed inside the distal connector. Therefore, the compensating assembly of the signal cable may be accommodated in the distal connector if desired based on application attributes.

In a second aspect, the present disclosure provides a sensing system for sensing an elevated voltage of a medium-voltage or high-voltage separable connector in a power distribution network of a national grid. The sensing system includes a sensored insulation plug for being inserted into a rear cavity of the medium-voltage or high-voltage separable connector in the power distribution network of the national grid, and operable to insulate a connection element of the separable connector on an elevated voltage. The sensored insulation plug includes a voltage sensor operable to generate a sensor signal indicative of the elevated voltage and a resistor electrically connected to the voltage sensor. The sensing system further includes a signal cable according to the first aspect. The connector is mechanically and electrically connected to the voltage sensor of the sensored insulation plug, such that the compensating assembly is electrically connected in parallel to the resistor.

In some embodiments, the resistor is a positive temperature coefficient (PTC) resistor. The PTC resistor may be used for temperature compensation purposes by maintaining a desired dividing ratio of the voltage divider over a range of temperatures of the voltage sensor.

Since the signal cable includes the compensating assembly operable to be electrically connected in parallel to the PTC resistor of the sensored insulation plug upon mechanical and electrical connection of the connector with the voltage sensor of the sensored insulation plug, there may be no need to mount a compensating capacitor directly onto the PCB of the sensored insulation plug. Therefore, there may be no need to change the compensating capacitor on a PCB and/or a PCB including the compensating capacitor for signal cables having different lengths for use with the sensored insulation plug.

The connector may be mechanically and electrically connected to the voltage sensor of the sensored insulation plug directly, i.e., without intermediate elements, such that a mechanical surface contact exists between the connector and the voltage sensor of the sensored insulation plug. Alternatively, the connector may be mechanically and electrically connected to the voltage sensor of the sensored insulation plug indirectly, i.e., via one or more intermediate elements such as a current transducer, such that a mechanical surface contact exists between the connector and an intermediate element, and between the intermediate element and the voltage sensor of the sensored insulation plug.

In some embodiments, the voltage sensor includes a voltage divider having a high-voltage capacitor electrically connected to the elevated voltage, a low-voltage capacitor electrically connected in series between the high-voltage capacitor and an electrical ground, and a signal contact electrically disposed between the high-voltage capacitor and the low-voltage capacitor. The positive temperature coefficient resistor is electrically connected in series between the signal contact and an output contact of the sensored insulation plug, and the signal cable is electrically connected to the output contact of the sensored insulation plug.

The voltage dividers including the high-voltage capacitor and the low-voltage capacitor may not require a conductive connection with components on the high voltage and may therefore be inherently safer.

In some embodiments, the sensing system further includes a current transducer operable to be mechanically and electrically connected to the connector of the signal cable for mechanically and electrically connecting the connector with the sensored insulation plug.

The current transducer may further generate a current transducer signal indicative of an electrical current of the separable connector to be conducted by the signal cable to the processing device for further processing.

In some embodiments, the compensating assembly is disposed inside the connector. Therefore, the compensating assembly of the signal cable may be accommodated in the connector if desired based on application attributes. Accommodation of the compensating assembly inside the connector may help save space and may facilitate easier handling of the signal cable.

The invention will now be described in more detail with reference to the following Figures exemplifying particular embodiments of the invention:

Fig. 1 illustrates a schematic sectional view of a separable connector and a sensored insulation plug, useable with a signal cable according to the present disclosure;

Fig. 2 illustrates a schematic disassembled view of a sensing system for sensing an elevated voltage of the separable connector, according to an embodiment of the present disclosure;

Fig. 3 illustrates a schematic perspective view of the sensing system of Figure 2, according to an embodiment of the present disclosure;

Fig. 4 illustrates a schematic perspective view of a signal cable of the sensing system of Figure 3, according to an embodiment of the present disclosure;

Fig. 5 illustrates a schematic, partially-sectional view of a connector of the signal cable of Figure 4, according to an embodiment of the present disclosure'

Fig. 6 illustrates a schematic circuit diagram of a sensing system, according to an embodiment of the present disclosure; and

Fig. 7 illustrates a schematic block diagram of a compensating assembly of a signal cable according to the present disclosure.

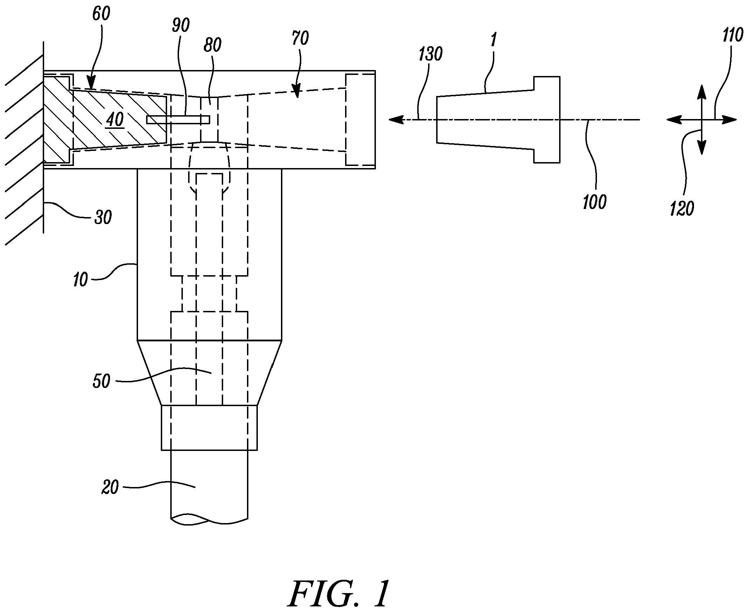

Now referring to the Figures, **Figure 1** illustrates a schematic sectional view of a separable power cable connector 10 and a sensored insulation plug 1, according to an embodiment of the present disclosure. The separable connector 10 is arranged at an end of a power cable 20. The separable connector 10 may be a medium-voltage or high-voltage separable connector 10. Further, the power cable 20 may be a medium-voltage or high-voltage power cable 20. The separable connector 10 connects, via a bushing 40, a power-carrying central conductor 50 of the power cable 20 to a switchgear 30 in a power distribution network of a national grid. The switchgear 30 may be a medium-voltage or high-voltage switchgear 30. For example, the separable connector 10 connects, via the bushing 40, the power-carrying central conductor 50 of the medium-voltage power cable 20 to the medium-voltage switchgear 30 in the power distribution network of the national grid. Similarly, the separable connector 10 connects, via the bushing 40, the power-carrying central conductor 50 of the high-voltage power cable 20 to the high-voltage switchgear 30 in the power distribution network of the national grid.

As shown in Figure 1, the separable connector 10 is a T-shaped separable connector 10 and includes a front cavity 60 for receiving the bushing 40, and a rear cavity 70 for receiving an insulation plug of a matching shape. The insulation plug may be a traditional insulation plug without elements of a sensor or the sensored insulation plug 1, according to an embodiment of the present disclosure, shown in Figure 1 to the right of the rear cavity 70, before being inserted into the rear cavity 70.

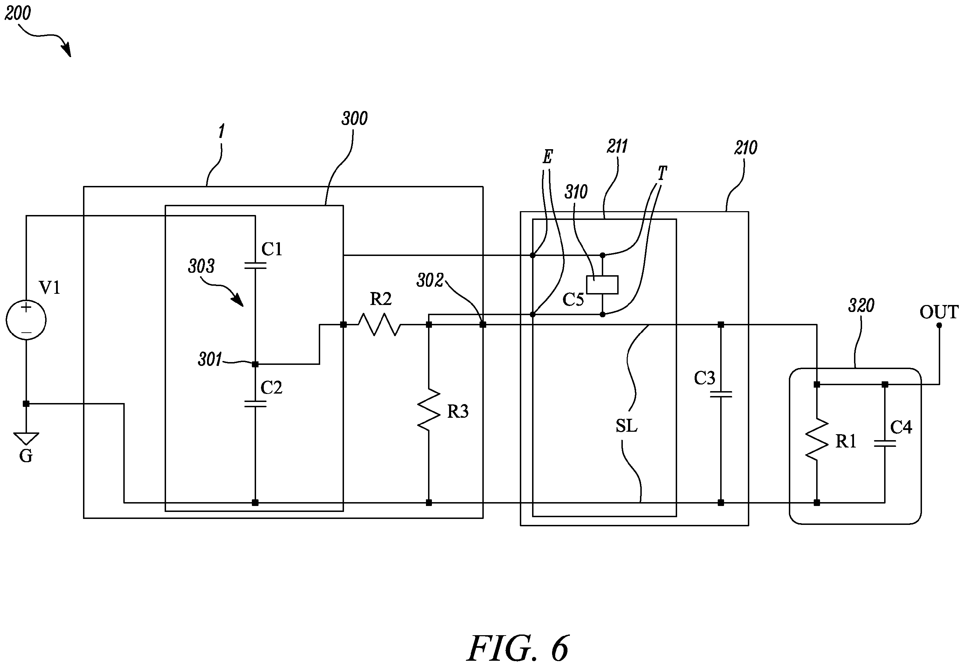

The traditional insulation plug and the sensored insulation plug 1 may both serve to electrically insulate a connection element 80 of the separable connector 10, which is electrically connected to the power-carrying central conductor 50 of the power cable 20 and can be electrically and mechanically connected to a conductive component of the bushing 40 via a threaded stud 90. In use, the connection element 80 is on an elevated voltage (such as V1 in Figure 6) of the power-carrying central conductor 50 of the power cable 20.

The sensored insulation plug 1 has an overall frusto-conical outer shape, generally rotationally symmetric about a plug axis 100 which defines axial directions 110 and radial directions 120, which are directions orthogonal to the axial directions 110. The sensored insulation plug 1 can be inserted into the rear cavity 70 by moving it axially in an axial insertion direction 130 into the rear cavity 70. The sensored insulation plug 1 may be turned by one or more revolutions about the plug axis 100 to be threadedly engaged and thereby electrically connected with the connection element 80 on the elevated voltage. The geometry of the sensored insulation plug 1 may be adapted to conform to ANSI/IEEE standard 386 to be suitable for a greater number of separable connectors 10. Depending on where the sensored insulation plug 1 is to be used, it could alternatively be adapted to conform to other standards or be adapted to fit into the most common types of separable connectors 10 in a specific area of the world.

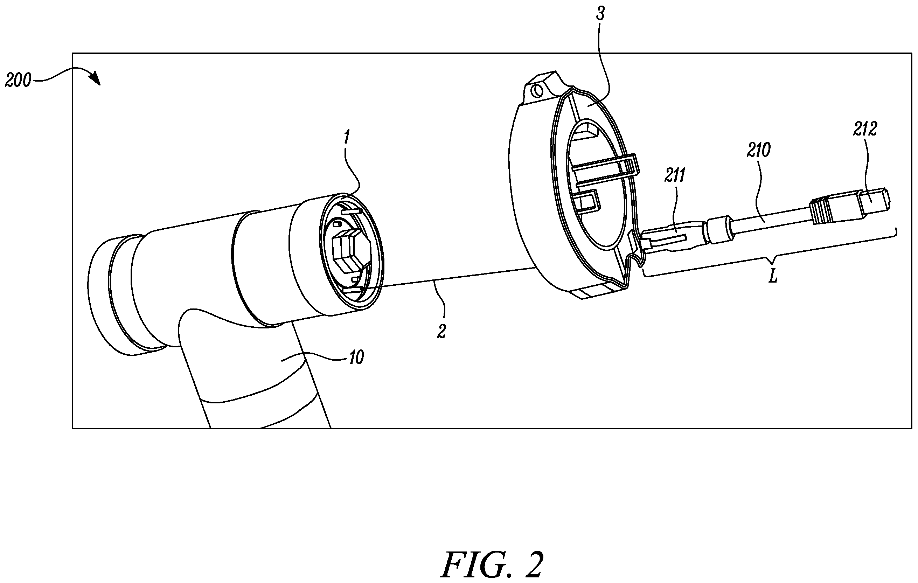

**Figure** 2 illustrates a schematic disassembled view of a sensing system 200 for sensing the elevated voltage of the medium-voltage or high-voltage separable connector 10 in the power distribution network of the national grid, according to an embodiment of the present disclosure.

The sensing system 200 includes the sensored insulation plug 1 inserted into the rear cavity 70 (shown in Figure 1) of the separable connector 10 in the power distribution network of the national grid. The sensored insulation plug 1 insulates the connection element 80 (shown in Figure 1) of the separable connector 10 on the elevated voltage.

The sensing system 200 further includes a signal cable 210 for conducting a sensor signal indicative of the elevated voltage. As shown in Figure 2, the signal cable 210 has a length L. The length L of the signal cable 210 may vary as per desired application attributes.

In the illustrated embodiment of Figure 2, the signal cable 210 is shown mechanically and electrically disconnected from the sensored insulation plug 1.

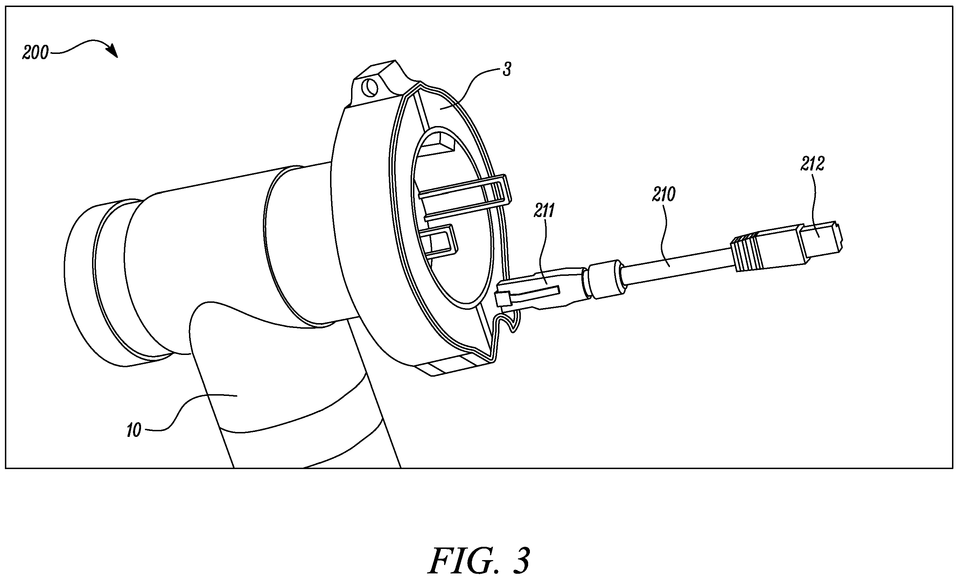

**Figure 3** illustrates a schematic perspective view of the sensing system 200 of Figure 2. Specifically, in the illustrated embodiment of Figure 3, the signal cable 210 is mechanically and electrically connected to the sensored insulation plug 1. The sensored insulation plug 1 is inserted into the separable power cable connector 10 and is therefore not visible in Figure 3. Specifically, the signal cable 210 is mechanically and electrically connected indirectly to the sensored insulation plug 1 via a current transducer 3. The signal cable 200 is mechanically and electrically connected directly to the current transducer 3, and the current transducer 3 is mechanically and electrically connected to the sensored insulation plug 1 via electrical connections which are not shown in Figure 3.

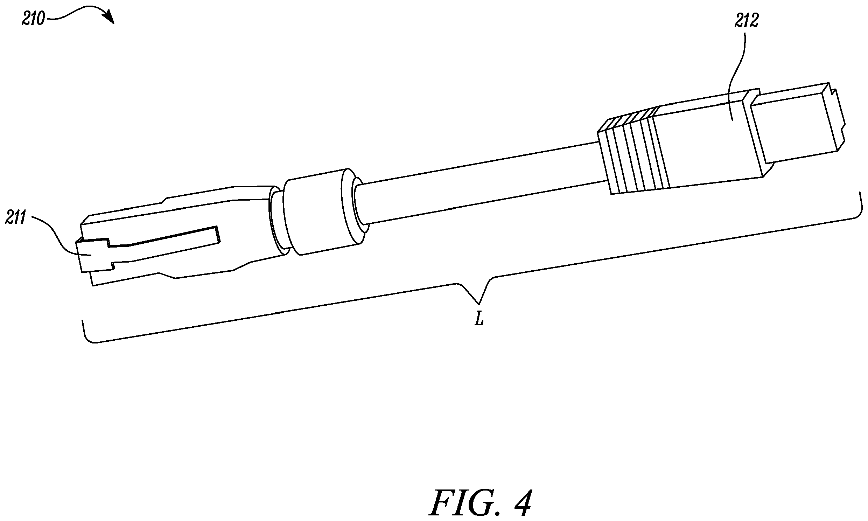

**Figure 4** is a schematic perspective view of the signal cable 210 of Figures 2 and 3. This signal cable 210 is an embodiment according to the present disclosure.

The signal cable 210 includes a connector 211 disposed at an end of the signal cable 210. In some embodiments, the signal cable 210 further includes a distal connector 212 disposed at an opposing end of the signal cable 210. The distal connector 212 is operable to connect the signal cable 210 with a processing device 320 (schematically shown in Figure 6) for processing the sensor signal. In some embodiments, the processing device 320 may be a remote terminal unit (RTU).

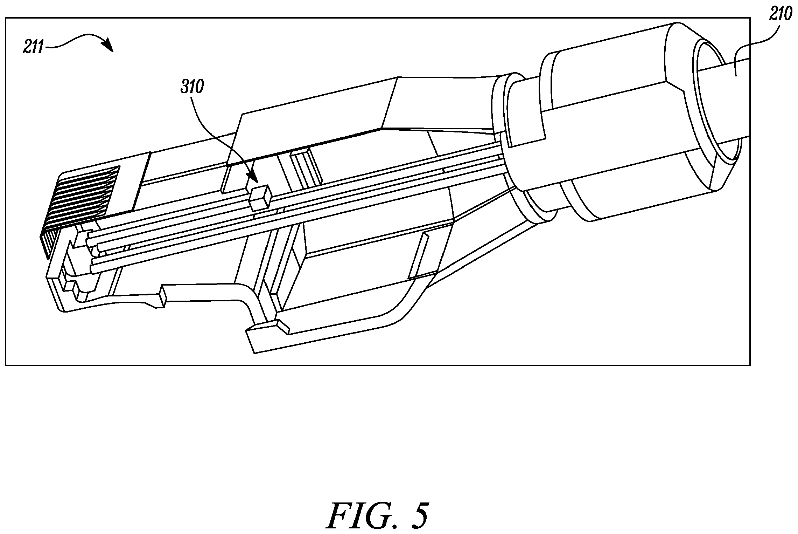

**Figure 5** is a schematic partially-sectional view of the connector 211 of the signal cable 210, according to an embodiment of the present disclosure. The connector 211 is a RJ45-type connector.

As shown in Figure 5, the signal cable 210 further includes a compensating assembly 310. In the illustrated embodiment of Figure 5, the compensating assembly 310 is disposed inside the connector 211. The compensating assembly 310 may be disposed on a printed circuit board (PCB) of the connector 211.

In some other embodiments, the compensating assembly 310 is disposed inside the distal connector 212 (shown in Figure 4). In some other embodiments, the compensating assembly 310 may be disposed in a different location in the signal cable 210. For example, the compensating assembly 310 may be disposed in a cable sheath of the signal cable 210 anywhere between the connector 211 and the distal connector 212.

Referring to Figures 2 to 5, in some embodiments, the sensing system 200 further includes the current transducer 3 operable to be mechanically and electrically connected to the connector 211 of the signal cable 210 for mechanically and electrically connecting the connector 211 with the sensored insulation plug 1. In some embodiments, the current transducer 3 is mechanically and electrically connected directly to the connector 211 of the signal cable 210. In some of these embodiments, the current transducer 3 is mechanically and electrically connected indirectly to the sensored insulation plug 1 via an intermediate element, such as a connection cable 2. In other ones of these embodiments, the current transducer 3 is mechanically and electrically connected directly to the sensored insulation plug 1, without any intermediate elements. However, in yet some other embodiments, the sensing system 200 does not include a current transducer 3 and the connector 211 of the signal cable 210 is directly mechanically and electrically connected with the sensored insulation plug 1.

**Figure 6** is a schematic circuit diagram of a sensing system 200, according to an embodiment of the present disclosure, such as the sensing system 200 illustrated in Figure 3.

In some embodiments, the sensored insulation plug 1 includes a voltage sensor 300 operable to sense the elevated voltage V1. The voltage sensor 300 is further operable to generate a sensor signal indicative of the elevated voltage. The sensored insulation plug 1 further includes a resistor R2 electrically connected to the voltage sensor 300. In some embodiments, the resistor R2 is a positive temperature coefficient (PTC) resistor. The resistor R2 may be interchangeably referred to as "the PTC resistor R2". The PTC resistor R2 may provide a certain temperature compensation for the sensor signal, so that variations of the dividing ratio of the voltage sensor 300 with variations in temperature of the voltage sensor 300 are reduced. This contributes to a more precise sensing of the elevated voltage under changing temperature conditions.

The signal cable 210 is operable to conduct the sensor signal received from the voltage sensor 300 of the sensored insulation plug 1.

In some embodiments, the voltage sensor 300 includes a voltage divider 303. The voltage divider 303 includes a high-voltage capacitor C1 electrically connected to the elevated voltage V1. The voltage divider 303 further includes a low-voltage capacitor C2 electrically connected in series between the high-voltage capacitor C1 and an electrical ground G. In other words, the positive temperature coefficient resistor R2 is electrically connected to the voltage divider 303 that includes the high-voltage capacitor C1 and the low-voltage capacitor C2.

As shown in Figure 6, the voltage divider 303 further includes a signal contact 301 electrically disposed between the high-voltage capacitor C1 and the low-voltage capacitor C2. A voltage which varies proportionally with the elevated voltage V1 can be picked up at the signal contact 301.

Furthermore, in the illustrated example of Figure 6, the PTC resistor R2 is electrically connected in series between the signal contact 301 and an output contact 302 of the sensored insulation plug 1.

The signal cable 210 is electrically connected to the output contact 302 of the sensored insulation plug 1 via the connector 211 as described above. In the illustrated embodiment of Figure 6, the connector 211 is electrically connected to the voltage sensor 300 of the sensored insulation plug 1.

The connector 211 is adapted to electrically connect the compensating assembly 310 to the voltage sensor 300 of the sensored insulation plug 1 upon mechanical and electrical connection of the connector 211

with the voltage sensor 300 of the sensored insulation plug 1.

Further, the connector 211 is mechanically and electrically connected to the voltage sensor 300 of the sensored insulation plug 1, such that the compensating assembly 310 is electrically connected in parallel to the PTC resistor R2 upon mechanical and electrical connection of the connector 211 with the voltage sensor 300 of the sensored insulation plug 1.

In some embodiments, the compensating assembly 310 includes two terminals T. Further, the connector 211 includes two electric contacts E electrically connected to the two terminals T and operable to electrically connect the compensating assembly 310 to the voltage sensor 300 of the sensored insulation plug 1.

In some embodiments, the compensating assembly 310 is electrically isolated from other electrical components when the connector 211 is mechanically and electrically disconnected from the voltage sensor 300 of the sensored insulation plug 1.

Furthermore, in some embodiments, the signal cable 210 further includes one or more signal lines SL electrically connected to two respective signal contacts of the connector 211 and operable to conduct the sensor signal from the voltage sensor 300 of the sensored insulation plug 1 upon mechanical and electrical connection of the connector 211 with the voltage sensor 300 of the sensored insulation plug 1. The two electric contacts E are electrically isolated from the one or more signals lines SL when the connector 211 is mechanically and electrically disconnected from the voltage sensor 300 of the sensored insulation plug 1.

In some embodiments, the sensored insulation plug 1 may further include a resistor R3. The resistor R3 may be used together with an input impedance (e.g., due to a resistor R1 and a capacitor C4 shown in Figure 6) of the processing device 320 to decrease a burden of the voltage sensor 300 to be able to use a lower resistance value of the resistor R2.

In some embodiments, a nominal capacitance of the compensating assembly 310 is selected based on a capacitance (shown as a capacitance C3 in Figure 6) of the signal cable 210 without the compensating assembly 310.

As discussed above, the capacitance of the signal cable 210 may change with the length L of the signal cable 210.

In some embodiments, the nominal capacitance of the compensating assembly 310 is between 1 nanofarad (nF) and 500 nF.

In some embodiments, the nominal capacitance of the compensating assembly 310 may be selected based on the equation provided below.

$$C5 = \frac{(C3+C4)}{R2} \cdot \left(\frac{R3.R1}{R3+R1}\right)$$

where,

C5 is the nominal capacitance of the compensating assembly 310;
C3 is the capacitance of the signal cable 210 without the compensating assembly 310;
C4 is an input capacitance of the processing device 320;
R1 is an input resistance of the processing device 320;
R2 is a resistance value of the PTC resistor R2 at a normal operating temperature of the sensored insulation plug 1; and
R3 is a resistance value of the resistor R3 of the sensored insulation plug 1.

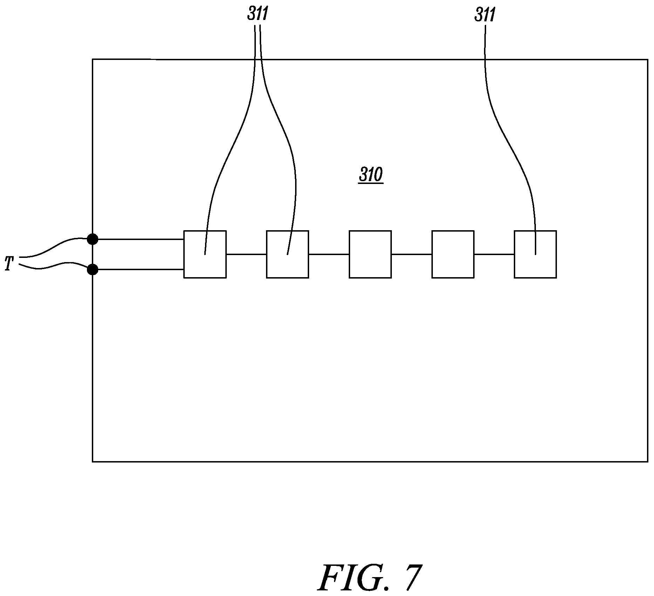

**Figure 7** illustrates a schematic block diagram of a compensating assembly 310, according to the present disclosure. Specifically, Figure 7 illustrates a schematic block diagram of the PCB of the connector 211 shown in Figure 5 on which the compensating assembly 310 may be disposed.

The compensating assembly 310 includes one or more discrete compensating capacitors 311. As shown in Figure 7, in some embodiments, the compensating assembly 310 includes five discrete compensating capacitors 311. However, in some other embodiments, the compensating assembly 310 may include any number of the discrete compensating capacitors 311, as per desired application attributes. In some embodiments, the one of more discrete compensating capacitors 311 may be surface mount capacitors (SMD). Any number of the discrete compensating capacitors 311 of the compensating assembly 310 may be electrically connected in series, parallel to each other, or both.

As discussed above, in some embodiments, the compensating assembly 310 includes the two terminals T. The two terminals T are configured to be connected to the electric contacts E of the connector 211 (shown in Figure 6).

In some embodiments, one of the one or more discrete compensating capacitors 311 may be electrically connected to the two terminals T of the compensating assembly 310. Therefore, the one of the one or more discrete compensating capacitors 311 may be electrically connected to the electric contacts E of the connector 211.

Referring to Figures 1 to 7, since the signal cable 210 includes the compensating assembly 310 for the frequency response compensation, the nominal capacitance of the compensating assembly 310 may be selected based on the capacitance of the signal cable 210. For example, the nominal capacitance of the compensating assembly 310 may be selected based on the capacitance of the signal cable 210 due to its length. Since there may be no need to mount a compensating capacitor 311 directly onto a PCB of the sensored insulation plug 1, there may be no need to change the PCB for the signal cable 10 for use with the sensored insulation plug 1.

Unless otherwise indicated, all numbers expressing feature sizes, amounts, and physical properties used in the specification and claims are to be understood as being modified by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein.

Although specific embodiments have been illustrated and described herein, it will be appreciated by those of ordinary skill in the art that a variety of alternate and/or equivalent implementations can be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

**Claims**

1. A signal cable (210) for conducting a sensor signal received from a voltage sensor (300) of a sensored insulation plug (1) for being inserted into a rear cavity (70) of a medium-voltage or high-voltage separable connector (10) in a power distribution network of a national grid, and operable to insulate a connection element (80) of the separable connector (10) on an elevated voltage and to sense the elevated voltage, the signal cable (210) comprising:

   a connector (211) disposed at an end of the signal cable (210), wherein the connector (211) is adapted to be mechanically and electrically connected to the voltage sensor (300) of the sensored insulation plug (1); the signal cable (210) being **characterized by** further comprising a compensating assembly (310) comprising one or more discrete compensating capacitors (311) and by the connector (211) being adapted to electrically connect the compensating assembly (310) to the voltage sensor (300) of the sensored insulation plug (1) upon mechanical and electrical connection of the connector (211) with the voltage sensor (300) of the sensored insulation plug (1).

2. The signal cable (210) according to claim 1, wherein the compensating assembly (310) is electrically isolated from other electrical components when the connector (211) is mechanically and electrically disconnected from the voltage sensor (300) of the sensored insulation plug (1).

3. The signal cable (210) according to any one of the preceding claims, wherein the compensating assembly (310) comprises two terminals (T), and wherein the connector (211) further comprises two electric contacts (E) electrically connected to the two terminals (T) and operable to electrically connect the compensating assembly (310) to the voltage sensor (300) of the sensored insulation plug (1).

4. The signal cable (210) according to claim 3, further comprising one or more signal lines (SL) electrically connected to two respective signal contacts of the connector (211) and operable to conduct the sensor signal from the voltage sensor of the sensored insulation plug (1) upon mechanical and electrical connection of the connector (211) with the voltage sensor (300) of the sensored insulation plug (1), wherein the two electric contacts (E) are electrically isolated from the one or more signals lines (SL) when the connector (211) is mechanically and electrically disconnected from the voltage sensor (300) of the sensored insulation plug (1).

5. The signal cable (210) according to any one of the preceding claims, wherein the compensating assembly (310) is operable to be electrically connected in parallel to a resistor (R2) of the sensored insulation plug (1) upon mechanical and electrical connection of the connector (211) with the voltage sensor (300) of the sensored insulation plug (1).

6. The signal cable (210) according to any one of the preceding claims, wherein the connector (211) is a RJ45-type connector.

7. The signal cable (210) according to any one of the preceding claims, wherein a nominal capacitance of the compensating assembly (310) is selected based on a capacitance (C3) of the signal cable (210) without the compensating assembly (310).

8. The signal cable (210) according to claim 7, wherein the nominal capacitance of the compensating assembly (310) is between 1 nanofarad (nF) and 500 nF.

9. The signal cable (210) according to any one of the preceding claims, further comprising a distal connector (212) disposed at an opposing end of the signal cable (210), the distal connector (212) being operable to connect the signal cable (210) with a processing device (320) for processing the sensor signal.

10. The signal cable (210) according to claim 9, wherein the compensating assembly (310) is disposed inside the distal connector (212).

11. A sensing system (200) for sensing an elevated voltage of a medium-voltage or high-voltage separable connector (10) in a power distribution network of a national grid, the sensing system (200) comprising:

> a sensored insulation plug (1) for being inserted into a rear cavity (70) of a medium-voltage or high-voltage separable connector (10) in a power distribution network of a national grid, and operable to insulate a connection element (80) of the separable connector (10) on an elevated voltage, the sensored insulation plug (1) comprising a voltage sensor (300) operable to generate a sensor signal indicative of the elevated voltage and a resistor (R2) electrically connected to the voltage sensor (300); and
> a signal cable (210) according to any one of the preceding claims, wherein the connector (211) is mechanically and electrically connected to the voltage sensor (300) of the sensored insulation plug (1), such that the compensating assembly (310) is electrically connected in parallel to the resistor (R2).

12. The sensing system (200) according to claim 11, wherein the resistor (R2) is a positive temperature coefficient resistor.

13. The sensing system (200) according to claim 12, wherein the voltage sensor (300) comprises a voltage divider (303) comprising a high-voltage capacitor (C1) electrically connected to the elevated voltage, a low-voltage capacitor (C2) electrically connected in series between the high-voltage capacitor (C1) and an electrical ground (G), and a signal contact (301) electrically disposed between the high-voltage capacitor (C1) and the low-voltage capacitor (C2), wherein the positive temperature coefficient resistor (R2) is electrically connected in series between the signal contact (301) and an output contact (302) of the sensored insulation plug (1), and wherein the signal cable (210) is electrically connected to the output contact (302) of the sensored insulation plug (1).

14. The sensing system (200) according to any one of claims 11 to 13, further comprising a current transducer (3) operable to be mechanically and electrically connected to the connector (211) of the signal cable (210) for mechanically and electrically connecting the connector (211) with the sensored insulation plug (1).

15. The signal cable (210) according to any one of claims 1 to 9, or the sensing system (200) according to any one of claims 11 to 14, wherein the compensating assembly (310) is disposed inside the connector (211).

**FIG. 1**

EP 4 585 930 A1

*FIG. 2*

*FIG. 3*

*FIG. 4*

*FIG. 5*

*FIG. 6*

*FIG. 7*

Europäisches
Patentamt

European
Patent Office

Office européen
des brevets

## EUROPEAN SEARCH REPORT

**Application Number**

EP 24 15 1174

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/040987 A1 (MAROWSKY RICHARD D [US] ET AL) 8 February 2018 (2018-02-08) | 1,2,5-10 | INV. G01R15/06 |
| Y | * paragraphs [0005], [0007], [0121], [0122]; figure 52 * | 11-15 | G01R15/14 G01R15/16 H01R24/64 |
| X | US 2012/068830 A1 (CAVENEY JACK E [US] ET AL) 22 March 2012 (2012-03-22) * paragraphs [0043], [0046]; figures 8-9 * | 1-6,9,10 | H04Q1/02 |
| Y | US 2023/384350 A1 (GRAVERMANN MARK [DE] ET AL) 30 November 2023 (2023-11-30) * paragraphs [0076], [0077], [0093], [0094]; figures 1-3 * | 11-15 | |

**TECHNICAL FIELDS SEARCHED (IPC)**

G01R
H01R
H04Q

---

The present search report has been drawn up for all claims

| Place of search | Date of completion of the search | Examiner |
|---|---|---|
| The Hague | 14 June 2024 | Decaix, François |

EPO FORM 1503 03.82 (P04C01)

## ANNEX TO THE EUROPEAN SEARCH REPORT
## ON EUROPEAN PATENT APPLICATION NO.

EP 24 15 1174

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2024

| Patent document cited in search report | Publication date | Patent family member(s) | | Publication date |
|---|---|---|---|---|
| US 2018040987 A1 | 08-02-2018 | EP | 3326246 A1 | 30-05-2018 |
| | | US | 2018040987 A1 | 08-02-2018 |
| | | WO | 2017015459 A1 | 26-01-2017 |
| US 2012068830 A1 | 22-03-2012 | EP | 2412168 A1 | 01-02-2012 |
| | | JP | 2012522428 A | 20-09-2012 |
| | | KR | 20120000064 A | 03-01-2012 |
| | | US | 2012068830 A1 | 22-03-2012 |
| | | WO | 2010111456 A1 | 30-09-2010 |
| US 2023384350 A1 | 30-11-2023 | NONE | | |

EPO FORM P0459

For more details about this annex : see Official Journal of the European Patent Office, No. 12/82

**REFERENCES CITED IN THE DESCRIPTION**

**Patent documents cited in the description**

- US 6031368 A

- EP 3070481 A1